(19) Europäisches Patentamt
European Patent Office
Office européen des brevets

(11) **EP 4 614 397 A1**

(12) **EUROPEAN PATENT APPLICATION**

(43) Date of publication:
**10.09.2025 Bulletin 2025/37**

(21) Application number: **25154160.3**

(22) Date of filing: **27.01.2025**

(51) International Patent Classification (IPC):
**G06N 7/01** (2023.01)    **G06F 30/27** (2020.01)
**G06N 20/00** (2019.01)    **G06N 20/20** (2019.01)

(52) Cooperative Patent Classification (CPC):
**G06N 7/01; G06F 30/27; G06N 20/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.03.2024 US 202418596239**

(71) Applicant: **The Boeing Company**
**Arlington, VA 22202 (US)**

(72) Inventors:
• **MOKALLED, Stefani**
**Arlington, 22202 (US)**

• **MICHAEL, Louisa**
**Arlington, 22202 (US)**
• **BOETTCHER, Philipp A.**
**Arlington, 22202 (US)**
• **BASU, Sabyasachi**
**Arlington, 22202 (US)**
• **WADSWORTH, Spencer G.**
**Arlington, 22202 (US)**

(74) Representative: **Bugnion S.p.A. - US1**
**Bugnion S.p.A.**
**Via Pancaldo 68**
**37138 Verona (IT)**

(54) **COMBINING TEST AND COMPUTATIONAL MODEL DATA FOR PREDICTING OBJECT PERFORMANCE**

(57)    The present disclosure provides a processor-implemented method in one aspect, the processor-implemented method including: generating a training data set including a plurality of exemplars, each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object; training a predictive model to predict the one or more properties of samples of the object based on the training data set; and predicting, using the predictive model, one or more properties of a new sample of the object.

FIG. 3

## Description

FIELD

Aspects of the present disclosure relate to training and using predictive models to predict object performance.

BACKGROUND

Testing the performance of physical objects is generally a time-consuming and inefficient process. Because the testing of each sample of a physical object involves the expenditure of an amount of time, manual testing may not be a scalable process. Thus, to accelerate the process of testing samples of physical objects to confirm that these samples comply with performance specifications (either alone or as part of an overall system), various modeling techniques can be used to minimize, or at least reduce, the amount of time needed to test the performance of an object.

Generally, the behavior of many physical objects in response to a stimulus or other input can be represented by mathematical physics models that model the behavior of these objects based on the properties of the stimulus or other input. These models may include, for example, finite element models or finite volume models that divide a system into multiple partial differential equations. However, the mathematical physics models that model the behavior of a physical object may generate results that diverge from the actual tested performance of the physical object, leading to inaccurate predictions of the performance of a sample, potential acceptance or rejection of samples that do not actually conform to a defined performance specification, and so on.

Accordingly, what is needed are techniques for improving the accuracy of predictive models used in predicting the performance properties of physical objects alone or as part of a larger system.

SUMMARY

The present disclosure provides a processor-implemented method in one aspect, the processor-implemented method including: generating a training data set including a plurality of exemplars, each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object; training a predictive model to predict the one or more properties of samples of the object based on the training data set; and predicting, using the predictive model, one or more properties of a new sample of the object.

In one aspect, in combination with any example processor-implemented method above or below, the predictive model comprises a linear regression model in which the ground-truth values for the one or more properties correspond to a dependent variable y in the linear regression model and the corresponding predicted values for the one or more properties correspond to an independent variable x in the linear regression model.

In one aspect, in combination with any example processor-implemented method above or below, training the predictive model comprises jointly learning one or more model error parameters $\beta$ and a random measurement error $\varepsilon$ based on a difference between the ground-truth values for the one or more properties and the corresponding predicted values for the one or more properties.

In one aspect, in combination with any example processor-implemented method above or below, the linear regression model is represented by an equation $y = \beta_0 + \beta_1 x + \varepsilon$, wherein $\beta_0$ and $\beta_1$ correspond to the one or more model error parameters $\beta$ and $\varepsilon$ is based on a normal distribution of values of y.

In one aspect, in combination with any example processor-implemented method above or below, the predictive model comprises a Markov Chain Monte Carlo (MCMC) model in which the ground-truth values for the one or more properties correspond to a dependent variable in the MCMC model and a function of (1) the corresponding predicted values x for the one or more properties and (2) an uncertainty parameter or factor $\theta$ corresponds to an independent variable in the MCMC model.

In one aspect, in combination with any example processor-implemented method above or below, the MCMC model is represented by an equation $y_{GT}(\boldsymbol{x}_i) = \rho y_{predicted}(x_i, \theta) + \delta + \varepsilon_i$, $x_i$ corresponds to a set of inputs used to generate the ground-truth values and predicted values of the one or more properties for an $i^{th}$ sample of the object, $y_{GT}(\boldsymbol{x}_i)$ corresponds to ground-truth values of the one or more properties for the $i^{th}$ sample of the object, $y_{predicted}$ corresponds to predicted values of the one or more properties for the $i^{th}$ sample of the object, $\theta$ corresponds to an uncertainty parameter, $\rho$ corresponds to a scale parameter for the predictive model, $\delta$ corresponds to a shift parameter applied to the computational model of the object, and $\varepsilon$ corresponds to a measurement error.

In one aspect, in combination with any example processor-implemented method above or below, training the predictive model comprises learning the uncertainty parameter $\theta$ based on an iterative process over a threshold number of training iterations.

In one aspect, in combination with any example processor-implemented method above or below, executing a training iteration from the threshold number of training iterations includes sampling a square error $\sigma^{-2}$ from a gamma distribution; sampling one or more model error parameters $\beta$ from a multivariate normal distribution; and sampling $\theta$ from a truncated normal distribution.

In one aspect, in combination with any example processor-implemented method above or below, the object comprises a coupling in an aerostructure; and predicting, using the predictive model, the one or more properties of a new sample of the object comprises predicting ignition properties of the coupling in the aerostructure.

In one aspect, in combination with any example processor-implemented method above or below, the processor-implemented method further includes rejecting the coupling based on a determination that the predicted ignition properties indicate that the coupling comprises an ignition source when an electrical impulse is introduced into the coupling.

Other aspects provide processing systems configured to perform the aforementioned methods as well as those described herein; non-transitory, computer-readable media comprising instructions that, when executed by one or more processors of a processing system, cause the processing system to perform the aforementioned methods as well as those described herein; a computer program product embodied on a computer readable storage medium comprising code for performing the aforementioned methods as well as those further described herein; and a processing system comprising means for performing the aforementioned methods as well as those further described herein.

BRIEF DESCRIPTION OF THE DRAWINGS

So that the manner in which the above recited features can be understood in detail, a more particular description, briefly summarized above, may be had by reference to example aspects, some of which are illustrated in the appended drawings.

Figure 1 depicts an example of experimental data and model predictions for the performance of a coupling in an aerostructure.

Figures 2A and 2B illustrate example pipelines for combining ground-truth test data and predictions generated by a computational model of an object to train and use a predictive model to accurately predict the performance properties of the object, according to aspects of the present disclosure.

Figure 3 illustrates example operations that may be performed, for example, by a computing system to combine ground-truth test data and predictions generated by a computational model of an object to train and use a predictive model to accurately predict the performance properties of the object, according to aspects of the present disclosure.

Figure 4 illustrates experimental data, baseline model predictions, and predictive model predictions for the performance of a coupling in an aerostructure, according to aspects of the present disclosure.

Figure 5 illustrates an example system on which aspects of the present disclosure can be performed.

DETAILED DESCRIPTION

The present disclosure relates to training and using predictive models to predict the performance of physical objects, alone or as part of a larger system represented by a physics or other mathematical model.

Performance properties of physical objects, on a standalone basis or as part of a larger system, may define the performance of the larger system. In order for the larger system to achieve defined performance characteristics, thus, the performance of components within the larger system should also meet target or threshold performance characteristics. When components within the larger system do not meet the corresponding target or threshold performance characteristics, the performance of the overall system may be degraded. For example, components of an aerostructure, such as a coupling joining two portions of an aerostructure together, may conduct electricity. When a sufficient amount of electricity is introduced into such a coupling, the coupling may generate localized pressure that may interact with other components of the aerostructure. If the coupling fails to meet a defined performance characteristic, such as the amount of pressure generated for a given amount of input current, the coupling may introduce a fire risk to other components in proximity with the coupling.

Because, as discussed, testing the performance properties of each sample of a physical object may be a time-consuming task, physics or other mathematical models can be used to predict the performance properties of samples of a physical object. However, these physics or mathematical models may be of limited use in predicting the performance properties of a sample of a physical object due to various factors. For example, physics models may assume an idealized, invariant environment in which the metrology devices used to obtain measurements or other data obtained about a sample of a physical object have uniform performance characteristics, the metrology devices are used consistently, and the parameters based on which the performance of a sample of a physical object are predicted are known. However, in the real world, measurement errors, noise in test data (e.g., from minor differences in the capabilities of various metrology devices), and uncertainty about the parameters based on which the performance of a sample of a physical object are predicted may cause the predictions generated by a physics or other mathematical model to diverge, potentially significantly, from the real-world performance of the sample. Further, while some parameters used in predicting the performance of a sample of an object are known *a priori*, calibrating these parameters may be a problem for which many solutions (having differing downstream effects) may exist.

Aspects of the present disclosure provide techniques for improving the accuracy of modeling techniques used to predict the performance properties of samples of a physical object by generating a predictive model based on ground-truth data and predictions generated by a baseline model (e.g., a FEM or FVM model that mathematically models the performance of a physical object in an idealized environment). Generally, the predictive model may be trained using Bayesian techniques to account for sources of uncertainty in the inputs based on which predictions are made by the baseline model and to estimate values of input parameters for which experimental measurements are not available. By doing so, aspects of the present disclosure may provide for predictive models that more accurately reflect the real-world performance of a physical object than the baseline model. Because the predictive models described herein generally allow for the generation of accurate predictions of physical object performance, aspects of the present disclosure may allow for such models to be used to calibrate parameters used in testing physical objects and to predict the performance of a physical object without manually testing these objects. Additionally, the predictive models disclosed herein may allow for efficient simulation of a physical environment and the performance characteristics of a physical object within the physical environment, which may reduce the computational expense involved in testing and simulating the performance of such an object using metrology devices and baseline models that may not accurately predict the performance of a physical object. Still further, the predictive models discussed herein may allow for improvements in the speed of generating and using sets of parameters for testing physical objects.

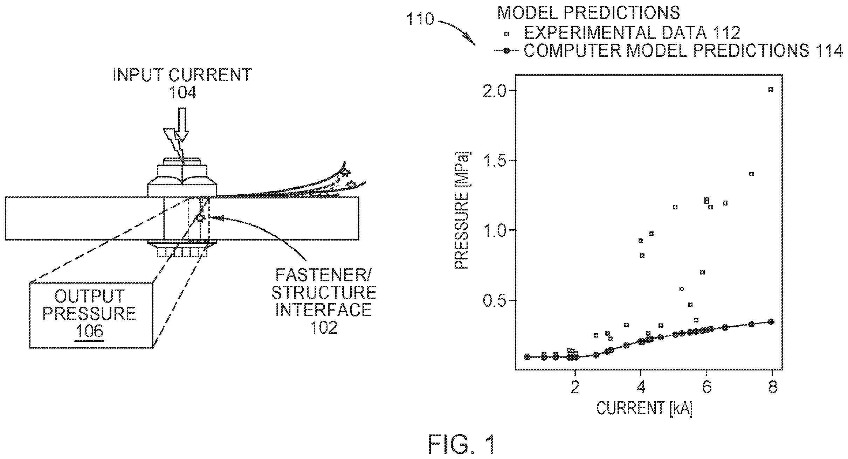

Figure 1 depicts an example of experimental data and model predictions for the performance of a coupling in an aerostructure.

As illustrated, portions of an aerostructure may be joined via a fastener/structure interface 102 through which a joining member (e.g., a rivet, bolt/nut combination, etc.) is positioned. In a situation in which lightning strikes the aerostructure, an input current 104 may be input into the fastener/structure interface 102 and generate a resulting output pressure that affects the aerostructure. Generally, because the fastener in the fastener/structure interface 102 may be made from a conductive material (e.g., may be a metallic object), the temperature in the fastener/structure interface 102 may increase, with a corresponding increase in output pressure 106. Based on the current and corresponding increase in output pressure 106, a prediction can be made of whether a sparking event will occur, thus completing the fire triangle of (1) an ignition source, (2) an oxidizer, and (3) a combustible material (e.g., the structure joined by the fastener at the fastener/structure interface).

In one example, the electrical energy output by a fastener when struck by lightning (thus introducing the input current 104 into the fastener/structure interface 102) may be represented by the equation

$$IV = m(T)c_v(T)\frac{dT}{dt} + m_0 h_{decomp}\frac{d\alpha}{dt}$$ , where

$m(T)c_v(T)\frac{dT}{dt}$ represents the heating of the fastener/structure interface 102 caused by the input current 104 and $m_0 h_{decomp}\frac{d\alpha}{dt}$ represents the energy spent in decomposing structural material proximate to the fastener/structure interface 102.

Generally, a baseline model may be used to predict the output pressure 106 generated through the introduction of an input current 104 into a fastener/structure interface 102. As illustrated, the baseline model may produce predictions 114. The predictions 114 may diverge significantly from experimental data 112 such that the predictions 114 generated by the baseline model do not accurately reflect the actual performance of the physical object in a variety of scenarios. For example, as illustrated, the experimental data 112 and the predictions 114 of an output pressure (in megapascals) may be similar at low input currents (e.g., of 2 kA or less). However, as the input current increases, the predictive power of the baseline model may diminish, with the predictive power of the baseline model being significantly worse (as illustrated by the divergence between the experimental data 112 and the corresponding predictions 114) at higher input currents. Thus, as discussed above, a baseline model may not allow for accurate simulation of the performance of a physical object or the identification of parameters defining the structure and behavior of the physical object.

To allow for predictive models to more accurately reflect the actual performance of a physical object, aspects of the present disclosure provide techniques for training a predictive model based on real-world experimental data (also referred to as "ground-truth test data") for a given set of test parameters and corresponding predictions made by a baseline model. In doing so, the predictive model may be trained to account for sources of uncertainty in generating inputs into the predictive model and to account for differences between ground-truth test data the idealized predictions made by the baseline model.

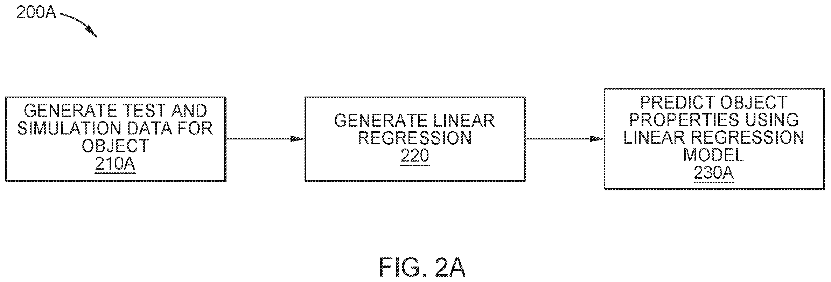

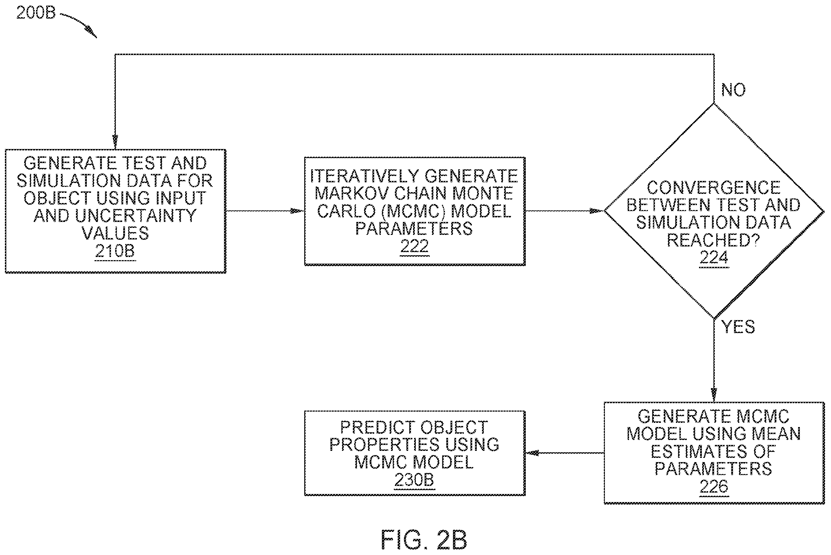

Figures 2A and 2B illustrate example pipelines 200A and 200B, respectively, for combining ground-truth test data and predictions generated by a computational model of an object to train and use a predictive model to accurately predict the performance properties of the object, according to aspects of the present disclosure.

Pipeline 200A illustrates an example in which the predictive model is a linear regression model. In the pipeline 200A, training and using the model to predict the performance properties of a sample of an object may begin at block 210A with generating ground-truth test data and simulation data for samples of an object. The ground-truth test data may be generated, for example, by applying inputs with a defined set of values into a physical object and using one or more metrology devices. Similarly, these defined values may be provided as inputs into a baseline model, which may be a mathematical model (e.g., an FEM, an FVM, a finite difference model, etc.) that simulates the performance of the sample of the physical object, to generate the simulation data for samples of the object.

The ground-truth truth data and the simulation data captured at block 210A may be input into block 220 for use in generating a linear regression model that predicts the performance of the physical object. In generating the linear regression model, the ground-truth test data may be defined as the dependent variable in the linear regression model, and the simulation data (or predicted values) generated by the baseline model may be defined as the independent variable in the linear regression model. The linear regression model may be represented by the equation:

$$ y = \beta_0 + \beta_1 x + \epsilon $$

where $y$ corresponds to the ground-truth test data, $\beta_0$ and $\beta_1$ correspond to learnable parameters modeling discrepancies between the ground-truth test data and the simulation data generated by the baseline model, and $\varepsilon$ corresponds to a random error term that simulates various measurement errors (e.g., in measuring the values of inputs used to generate the ground-truth test data and the simulation data, in measuring the ground-truth test data, etc.).

For each pairing of a sample of ground-truth test data and corresponding predicted values (simulation data) generated by a baseline model, the value of $\varepsilon$ may be a value selected from a Gaussian distribution. By doing so, the linear regression model may add a random amount of noise to an error-corrected prediction generated by a baseline model simulating the performance of a physical object to account for sources of uncertainty or other random errors in the input parameters and/or measured outputs of the sample of the physical object.

Subsequently, at block 230A, the linear regression model can be used to predict the performance properties of other samples of the physical object. Generally, the linear regression model may be used to identify the range of predicted performance properties of the physical object, excluding outliers more than a threshold distance away from the mean. For example, the linear regression model can be used to identify the 95% prediction interval for the performance characteristics of the physical object, or in other words, the predicted performance of the physical object up to two standard deviations from the mean.

In another example, as illustrated by the pipeline 200B, the predictive model may be a Markov Chain Monte Carlo (MCMC) model trained using an iterative process. In an MCMC model, error, uncertainty, and error variance values may be iteratively sampled over a number of iterations in order to generate a predictive model that accurately reflects the ground-truth values captured for the sample of the physical object based on corresponding predictions generated by a baseline model based on a set of known parameters and a set of unknown parameters for which estimated values are used. The set of unknown parameters may include any number of unknown parameters.

At block 21 0B, the ground-truth truth test data may be generated, for example, by applying inputs with a defined set of values to a sample of the physical object and using one or more metrology devices such that the $i^{th}$ sample of ground-truth test data is represented by the expression $y_{GT}(x_i)$, where $x_i$ represents a vector of the inputs with the defined set of values for the $i^{th}$ sample. Similarly, these defined values $x_i$ may be provided as inputs into a baseline model, which may be a mathematical model (e.g., an FEM, an FVM, a finite difference model, etc.) that simulates the performance of the sample of the physical object, to generate the simulation data for samples of the physical object. Generally, the simulation data for the samples of the physical object may be represented by the expression $y_{predicted}(x_i, \theta)$ and be calculated as a function of the defined values $x_i$ and one or more uncertainty parameters $\theta$ which may be estimated (e.g., based on prior values of learned uncertainty parameters $\theta$ generated from a prior version of the predictive model or *a priori* defined (e.g., estimated) starting values for the uncertainty parameters $\theta$).

The ground-truth test data and the simulation data generated at block 210B may be used at block 222 to iteratively generate MCMC model parameters using Bayesian sampling techniques. The MCMC model parameters generated at block 222 may include, for example, the uncertainty parameters $\theta$, a scale parameter $\rho$, and a shift parameter $\delta$ applied to the outputs of the baseline (computational) model used in generating the simulation data at block 210B. In some aspects, the parameters $\rho$ and $\delta$ may be used to generate one or more error parameters $\beta$ such that $\beta = (\delta, p)^T$ (e.g., the error parameters $\beta$ may be represented as a transpose of $\rho$ and $\delta$). Finally, a measurement error term $\varepsilon$ may be a normal distribution $N(0, \sigma^2)$ that is estimated, with $\sigma^2$ representing the variance of a Gaussian distribution of noise. Based on these parameters, the MCMC model may be represented by the equation:

$$ y_{GT}(x_i) = \rho y_{predicted}(x_i, \theta) + \delta + \epsilon_i $$

where i represents the $i^{th}$ of S samples used at block 222 to iteratively generate the MCMC parameters.

In some aspects, block 222 may begin with initializing $\sigma^{-2}$, $\theta$, and $\beta$ as a gamma distribution, a truncated normal distribution, and a multivariate normal distribution, respectively. The terms $\sigma^{-2}$, $\theta$, and $\beta$ may be used as a prior distribution and may be used in conjunction with a likelihood function to derive posterior distributions based on which $\sigma^{-2}$, $\theta$, and $\beta$ are sampled during

each iteration of generating MCMC model parameters at block 222. Generally, an iteration for generating the MCMC model parameters may include sampling $\sigma^{-2}$ from a gamma distribution using Gibbs sampling techniques. After sampling $\sigma^{-2}$, $\beta$ may be sampled from a multivariate normal distribution using Gibbs sampling techniques. As discussed, because $\beta$ may be represented as a transpose of the scale parameter $\rho$ and shift parameter $\delta$, the multivariate normal distribution based on which $\beta$ is sampled may result in the sampling of the appropriate scale parameter $\rho$ and shift parameter $\delta$ that moves a predicted value for the performance properties of a physical object towards the corresponding ground-truth performance properties measured at block 210B. Finally, after sampling $\beta$, the uncertainty parameter $\theta$ may be sampled from a truncated normal distribution using Metropolis-Hastings sampling techniques.

At block 224, it may be determined whether convergence between the ground-truth test data and the simulation data (modified based on the MCMC model parameters) has been reached. Generally, convergence between the ground-truth test data and the simulation data may be deemed to have been reached when the cumulative divergence between ground-truth test data and corresponding simulation data is less than a threshold value.

If, at block 224, it is determined that the ground-truth test and simulation data has not converged, operations may return to block 210A in the pipeline 200A to generate a subsequent set of ground-truth test data and corresponding simulation data for use in further refining the parameters of the MCMC parameter.

If, however, at block 224, it is determined that the ground-truth test and simulation data has converged, then at block 226, operations proceed with generating the MCMC model using the mean estimates of the parameters. Then, at block 230B, the MCMC model can be used to predict the performance properties of other samples of the physical object.

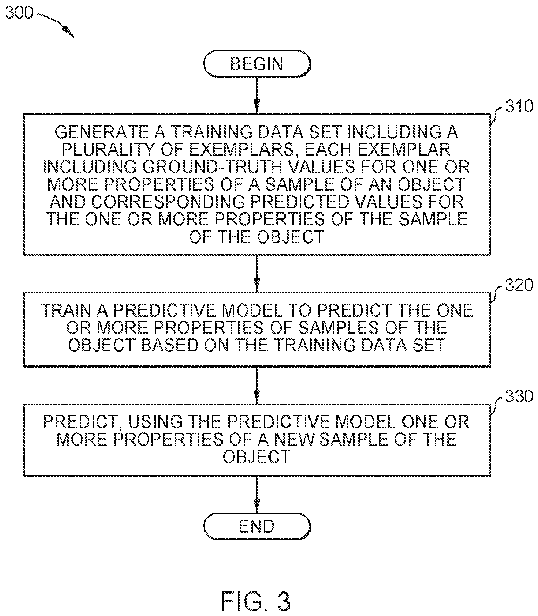

Figure 3 illustrates example operations 300 that may be performed, for example, by a computing system to combine ground-truth test data and predictions generated by a computational model of an object to train and use a predictive model to accurately predict the performance properties of the object, according to aspects of the present disclosure.

As illustrated, operations 300 begin at block 310 with generating a training data set including a plurality of exemplars. Generally, each exemplar of the plurality of exemplars includes ground-truth values for one or more properties of a sample of an object and corresponding predicted values for the one or more properties of the sample of the object. The ground-truth values for the one or more properties of the sample of the object may be obtained using one or more metrology devices, and the corresponding predicted values for the one or more properties of the sample of the object may be generated based on a computational model of the object. The computational model of the object may, for example, be an FEM, and FVM, a finite difference model, or other model that models the performance of the object in an idealized environment.

At block 320, operations 300 proceed with training a predictive model to predict the one or more properties of samples of the object based on the training data set.

In some aspects, the predictive model may be a linear regression model. In such a model, the ground-truth values for the one or more properties may correspond to a dependent variable $y$ in the linear regression model, and the corresponding predicted values for the one or more properties may correspond to an independent variable x in the linear regression model.

In some aspects, training the predictive model may include jointly learning one or more model error parameters $\beta$ and a random measurement error $\varepsilon$ based on a difference between the ground-truth values for the one or more properties and the corresponding predicted values for the one or more properties.

In some aspects, the linear regression model may be represented by the equation $y = \beta_0 + \beta_1 x + \varepsilon$, wherein $\beta_0$ and $\beta_1$ correspond to the one or more model error parameters $\beta$ and $\varepsilon$ is based on a normal distribution of values of y.

In some aspects, the predictive model may be a Markov Chain Monte Carlo (MCMC) model. In such a case, the ground-truth values for the one or more properties may correspond to a dependent variable in the MCMC model and a function of (1) the corresponding predicted values x for the one or more properties and (2) an uncertainty factor $\theta$ may correspond to an independent variable in the MCMC model.

In some aspects, the MCMC model is represented by an equation $y_{GT}(x_i) = \rho y_{predicted}(x_i, \theta) + \delta + \varepsilon_i$. $x_i$ may correspond to a set of inputs used to generate the ground-truth values and predicted values of the one or more properties for an $i^{th}$ sample of the object. $y_{GT}(x_i)$ generally represents ground-truth values of the one or more properties for the $i^{th}$ sample of the object, and $y_{predicted}$ generally represents to predicted values of the one or more properties for the $i^{th}$ sample of the object. $\theta$ corresponds to an uncertainty parameter, which may be learned during training of the MCMC. $\rho$ may correspond to a scale parameter for the predictive model, $\delta$ may correspond to a shift parameter applied to the computational model of the object, and $\varepsilon$ may correspond to a measurement error.

In some aspects, training the predictive model comprises learning the uncertainty parameter $\theta$ based on an iterative process over a threshold number of training iterations.

In some aspects, executing a training iteration from the threshold number of training iterations may include sampling a square error $\sigma^{-2}$ from a gamma distribution. One or more model error parameters $\beta$ may be sampled from a multivariate normal distribution (e.g.,

from a normal distribution over the shift parameter $\delta$ and the scale parameter $\rho$). Finally, $\theta$ may be sampled from a truncated normal distribution.

At block 330, operations 300 proceed with predicting, using the predictive model, one or more properties of a new sample of the object.

In some aspects, the object may be a coupling in an aerostructure. The coupling may, for example, be a bolt, rivet, or other fastener that joins different structural components of an aerostructure together through a fastener/structure interface. The predicting may include predicting ignition properties of the coupling in the aerostructure. In some aspects, the operations 300 may further include rejecting the coupling based on a determination that the predicted ignition properties indicate that the coupling comprises an ignition source when an electrical impulse is introduced into the coupling.

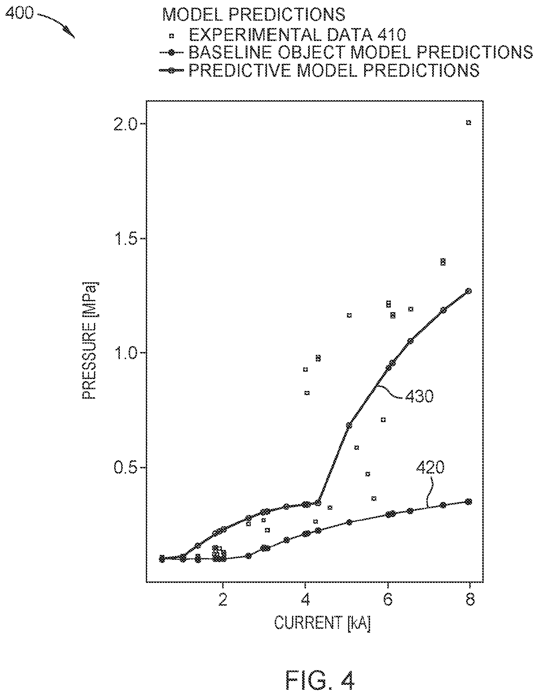

Figure 4 illustrates experimental data, baseline model predictions, and predictive model predictions for the performance of a coupling in an aerostructure, according to aspects of the present disclosure.

As illustrated, the experimental test data 410 represents ground-truth test data obtained for a sample of a physical object, and the baseline object model prediction 420 represents predictions of physical object performance generated by a computational model of the object (e.g., an FEM, FVM, FDM, etc.). Using the techniques discussed herein, aspects of the present disclosure may result in a predictive model that generates predictive model predictions 430 of physical object performance that more closely approximates the ground-truth measured performance of the physical object. For example, as discussed above, the baseline object model predictions 420 of an output pressure (in megapascals) may closely reflect the ground-truth tested performance of output pressure for a given input current at low input currents (e.g., of 2 kA or less), but the correlation between the baseline object model predictions 420 and the experimental test data 410 may diminish as the input current increases.

Using the techniques discussed herein, the predictive model predictions 430 may diverge from the baseline object model predictions 420. For example, as illustrated, the predictive model predictions 430 of output pressure may generally have a smaller divergence from the ground-truth experimental data 410 for a given input current value than the corresponding baseline object model predictions 420. Because the predictive model predictions 430 may more closely resemble ground-truth, or real-life, performance of a physical object, the baseline model may be used to accelerate the process of testing the performance of physical objects and identifying the values of parameters to be used in testing or simulating the performance of these physical objects.

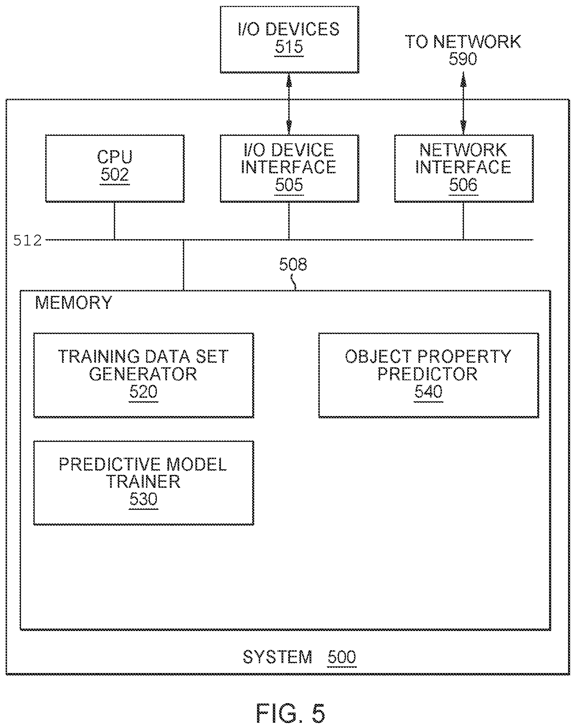

Figure 5 illustrates an example system 500 on which aspects of the present disclosure can be performed.

As shown, system 500 includes a central processing unit (CPU) 502, one or more I/O device interfaces 504 that may allow for the connection of various I/O devices 514 (e.g., keyboards, displays, mouse devices, pen input, etc.) to the system 500, network interface 506 through which system 500 is connected to network 590 (which may be a local network, an intranet, the internet, or any other group of computing devices communicatively connected to each other), a memory 508, and an interconnect 512.

CPU 502 may retrieve and execute programming instructions stored in the memory 508. Similarly, the CPU 502 may retrieve and store application data residing in the memory 508. The interconnect 512 transmits programming instructions and application data, among the CPU 502, I/O device interface 504, network interface 506, and memory 508.

CPU 502 is included to be representative of a single CPU, multiple CPUs, a single CPU having multiple processing cores, and the like.

Memory 508 is representative of a volatile memory, such as a random access memory, or a nonvolatile memory, such as nonvolatile random access memory, phase change random access memory, or the like. As shown, memory 508 includes a training data set generator 520, a predictive model trainer 530, and an object property predictor 540. The training data set generator 520 generally generates a training data set including exemplars of ground-truth and predicted value pairings. Generally, the ground-truth values may be performance data obtained based on the measured properties of a sample of a physical object for which a predictive model is to be trained, and the predicted values may be simulated performance data obtained using a baseline computational model representing the physical object or an overall system in which the physical object is a component. The baseline computational model may be, for example, a FEM, FVM, FDM, or other model that mathematically models the performance of a physical object in an idealized environment.

The predictive model trainer 530 uses the ground-truth and predicted value pairings to generate a predictive model that more accurately predicts the performance of the physical object than the baseline computational model used to generate the predicted values in the training data set. The predictive model trainer 530 may train the predictive model, for example, as a linear regression model, a Markov Chain Monte Carlo model, or other model that is trained based, at least in part, on differences between the ground-truth values and predicted values in each pairing in the training data set. In some aspects, the predictive model trainer 530 can train a linear regression model based on a learned model error parameter modeling a divergence between the ground-truth values and predicted values and a measurement error. In some aspects, the predictive model trainer 530 can train a Markov Chain Monte Carlo model trained based on iterative sampling of shift, scale, and uncertainty parameters. After verifying that the predictive model has converged with the ground-truth data, the predictive model trainer 530 can deploy the predictive model to the object property predictor 540 for use in predicting the performance properties of a physical object, identifying the values of various parameters to be used in testing or predicting the performance of the physical object, and the like.

In the current disclosure, reference is made to various aspects. However, it should be understood that the present disclosure is not limited to specific described aspects. Instead, any combination of the following features and elements, whether related to different aspects or not, is contemplated to implement and practice the teachings provided herein. Additionally, when elements of the aspects are described in the form of "at least one of A and B," it will be understood that aspects including element A exclusively, including element B exclusively, and including element A and B are each contemplated. Furthermore, although some aspects may achieve advantages over other possible solutions and/or over the prior art, whether or not a particular advantage is achieved by a given aspect is not limiting of the present disclosure. Thus, the aspects, features, aspects and advantages disclosed herein are merely illustrative and are not considered elements or limitations of the appended claims except where explicitly recited in a claim(s). Likewise, reference to "the invention" shall not be construed as a generalization of any inventive subject matter disclosed herein and shall not be considered to be an element or limitation of the appended claims except where explicitly recited in a claim(s).

As will be appreciated by one skilled in the art, aspects described herein may be embodied as a system, method or computer program product. Accordingly, aspects may take the form of an entirely hardware aspect, an entirely software aspect (including firmware, resident software, micro-code, etc.) or an aspect combining software and hardware aspects that may all generally be referred to herein as a "circuit," "module" or "system." Furthermore, aspects described herein may take the form of a computer program product embodied in one or more computer readable storage medium(s) having computer readable program code embodied thereon.

Program code embodied on a computer readable storage medium may be transmitted using any appropriate medium, including but not limited to wireless, wireline, optical fiber cable, RF, etc., or any suitable combination of the foregoing.

Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to aspects of the present disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various aspects of the present disclosure. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order or out of order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

While the foregoing is directed to aspects of the present disclosure, other and further aspects of the disclosure may be devised without departing from the basic scope thereof, and the scope thereof is determined by the claims that follow.

Further examples and combinations thereof include the following:

Clause 1. A processor-implemented method, comprising:

generating a training data set including a plurality of exemplars (210A, 210B, 310), each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object;
training a predictive model to predict the one or more properties of samples of the object based on the training data set (220, 222, 224, 226, 320); and
predicting, using the predictive model, one or more properties of a new sample of the object (230A, 230B, 330).

Clause 2. The method of Clause 1, wherein the predictive model comprises a linear regression model (220) in which the ground-truth values for the one or more properties correspond to a dependent variable y in the linear regression model and the corresponding predicted values for the one or more properties correspond to an independent variable x in the linear regression model.

Clause 3. The method of Clause 2, wherein training the predictive model comprises jointly learning one or more model error parameters $\beta$ and a random measurement error $\varepsilon$ based on a difference between the ground-truth values for the one or more properties and the corresponding predicted values for the one or more properties.

Clause 4. The method of Clause 3, wherein the linear regression model is represented by an equation $y = \beta_0 + \beta_1 x + \varepsilon$, wherein $\beta_0$ and $\beta_1$ correspond to the one or more model error parameters $\beta$ and $\varepsilon$ is based on a normal distribution of values of $y$.

Clause 5. The method of Clause 1, wherein the predictive model comprises a Markov Chain Monte Carlo (MCMC) model (222, 224, 226) in which the ground-truth values for the one or more properties correspond to a dependent variable in the MCMC model and a function of (1) the corresponding predicted values x for the one or more properties and (2) an uncertainty factor $\theta$ corresponds to an independent variable in the MCMC model. Clause 6. The method of Clause 5, wherein:

the MCMC model is represented by an equation $y_{GT}(x_i) = \rho y_{predicted}(x_i, \theta) + \delta + \varepsilon_i$,
$x_i$ corresponds to a set of inputs used to generate the ground-truth values and predicted values of the one or more properties for an $i^{th}$ sample of the object,
$y_{GT}(x_i)$ corresponds to ground-truth values of the one or more properties for the $i^{th}$ sample of the object,
$y_{predicted}$ corresponds to predicted values of the one or more properties for the $i^{th}$ sample of the object,
$\theta$ corresponds to an uncertainty parameter,
$\rho$ corresponds to a scale parameter for the predictive model,
$\delta$ corresponds to a shift parameter applied to the computational model of the object, and
$\varepsilon$ corresponds to a measurement error.

Clause 7. The method of Clause 6, wherein training the predictive model comprises learning $\theta$ based on an iterative process (210B, 222, 224) over a threshold number of training iterations.

Clause 8. The method of Clause 7, wherein executing a training iteration (222) from the threshold number of training iterations comprises:

sampling a square error $\sigma^{-2}$ from a gamma distribution;
sampling one or more model error parameters $\beta$ from a multivariate normal distribution; and
sampling $\theta$ from a truncated normal distribution.

Clause 9. The method of Clause 1, wherein:

the object comprises a coupling in an aerostructure (102); and
predicting, using the predictive model, the one or more properties of a new sample of the object comprises predicting ignition properties of the coupling in the aerostructure. Clause 10. The method of Clause 9, further comprising rejecting the coupling based on a determination that the predicted ignition properties indicate that the coupling comprises an ignition source when an electrical impulse is introduced into the coupling.

Clause 11. A system (500), comprising:

a memory having executable instructions stored thereon (508); and
one or more processors (502) configured to execute the executable instructions to cause the system to:

generating a training data set including a plurality of exemplars (210A, 210B, 310), each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object;
training a predictive model to predict the one or more properties of samples of the object based on the training data set (220, 222, 224, 226, 320); and
predicting, using the predictive model, one or more properties of a new sample of the object (230A, 230B, 330).

Clause 12. The system of Clause 11, wherein the predictive model comprises a linear regression model (220) in which the ground-truth values for the one or more properties correspond to a dependent variable $y$ in the linear regression model and the corresponding predicted values for the one or more properties correspond to an independent variable x in the linear regression model.

Clause 13. The system of Clause 12, wherein to train the predictive model, the one or more processors are configured to cause the system to jointly learn one or more model error parameters $\beta$ and a random measurement error $\varepsilon$ based on a difference between the ground-truth values for the one or more properties and the corresponding predicted values for the one or more properties.

Clause 14. The system of Clause 13, wherein the linear regression model is represented by an equation $y = \beta_0 + \beta_1 x + \varepsilon$, wherein $\beta_0$ and $\beta_1$ correspond to the one or more model error parameters $\beta$ and $\varepsilon$ is based on a normal distribution of values of y.

Clause 15. The system of Clause 11, wherein the predictive model comprises a Markov Chain Monte Carlo (MCMC) model (222, 224, 226) in which the ground-truth values for the one or more properties correspond to a dependent variable in the MCMC model and a function of (1) the corresponding predicted values x for the one or more properties and (2) an uncertainty factor $\theta$ corresponds to an independent variable in the MCMC model.

Clause 16. The system of Clause 15, wherein:

the MCMC model is represented by an equation $y_{GT}(x_i) = \rho y_{predicted}(x_i, \theta) + \delta + \varepsilon_i$,
$x_i$ corresponds to a set of inputs used to generate the ground-truth values and predicted values of the one or more properties for an $i^{th}$ sample of the object,
$y_{GT}(x_i)$ corresponds to ground-truth values of the one or more properties for the $i^{th}$ sample of the object,
$y_{predicted}$ corresponds to predicted values of the one or more properties for the $i^{th}$ sample of the object,
$\theta$ corresponds to an uncertainty parameter,
$\rho$ corresponds to a scale parameter for the predictive model,
$\delta$ corresponds to a shift parameter applied to the computational model of the object, and
$\varepsilon$ corresponds to a measurement error.

Clause 17. The system of Clause 16, wherein to train the predictive model, the one or more processors are configured to cause the system to learn $\theta$ based on an iterative process (210B, 222, 224) over a threshold number of training iterations..

Clause 18. The system of Clause 17, wherein to execute a training iteration (222) from the threshold number of training iterations, the one or more processors are configured to cause the system to:

sample a square error $\sigma^{-2}$ from a gamma distribution;
sample one or more model error parameters $\beta$ from a multivariate normal distribution; and
sample $\theta$ from a truncated normal distribution.

Clause 19. The system of Clause 11, wherein:

the object comprises a coupling in an aerostructure (102);
to predict, using the predictive model, the one or more properties of a new sample of the object, the one or more processors are configured to cause the system to predict ignition properties of the coupling in the aerostructure; and
the one or more processors are further configured to cause the system to reject the coupling based on a determination that the predicted ignition properties indicate that the coupling comprises an ignition source when an electrical impulse is introduced into the coupling.

Clause 20. A non-transitory computer-readable medium having executable instructions stored thereon which, when executed by one or more processors, performs an operation comprising:

generating a training data set including a plurality of exemplars (210A, 210B, 310), each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object; training a predictive model to predict the one or more properties of samples of the object based on the training data set (220, 222, 224, 226, 320); and predicting, using the predictive model, one or more properties of a new sample of the object (230A, 230B, 330).

**Claims**

1. A computer-implemented method (300), comprising:

   generating a training data set including a plurality of exemplars (210A; 210B; 310), each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object; training a predictive model to predict the one or more properties of samples of the object based on the training data set (320); and predicting, using the predictive model, one or more properties of a new sample of the object (230A; 230B; 330).

2. The method (300) of claim 1, wherein the predictive model comprises a linear regression model (220) in which the ground-truth values for the one or more properties correspond to a dependent variable $y$ in the linear regression model and the corresponding predicted values for the one or more properties correspond to an independent variable x in the linear regression model.

3. The method (300) of claim 2, wherein training the predictive model (320) comprises jointly learning one or more model error parameters $\beta$ and a random measurement error $\varepsilon$ based on a difference between the ground-truth values for the one or more properties and the corresponding predicted values for the one or more properties.

4. The method (300) of claim 3, wherein the linear regression model is represented by an equation $y = \beta_0 + \beta_1 x + \varepsilon$, wherein $\beta_0$ and $\beta_1$ correspond to the

one or more model error parameters $\beta$ and $\varepsilon$ is based on a normal distribution of values of $y$.

5. The method (300) of claim 1, wherein the predictive model comprises a Markov Chain Monte Carlo, MCMC, model (222) in which the ground-truth values for the one or more properties correspond to a dependent variable in the MCMC model and a function of the corresponding predicted values x for the one or more properties and an uncertainty parameter $\theta$ corresponds to an independent variable in the MCMC model.

6. The method (300) of claim 5, wherein:

   the MCMC model is represented by an equation $y_{GT}(\mathbf{x}_i) = \rho y_{predicted}(x_i, \theta) + \delta + \varepsilon_i$, in which
   $\mathbf{x}_i$ corresponds to a set of inputs used to generate the ground-truth values and predicted values of the one or more properties for an $i^{th}$ sample of the object,
   $y_{GT}(\mathbf{x}_i)$ corresponds to ground-truth values of the one or more properties for the $i^{th}$ sample of the object,
   $y_{predicted}$ corresponds to predicted values of the one or more properties for the $i^{th}$ sample of the object,
   $\theta$ corresponds to an uncertainty parameter,
   $\rho$ corresponds to a scale parameter for the predictive model,
   $\delta$ corresponds to a shift parameter applied to the computational model of the object, and
   $\varepsilon$ corresponds to a measurement error.

7. The method (300) of claim 5 or 6, wherein training the predictive model (320) comprises learning the uncertainty parameter $\theta$ based on an iterative process (210B, 222, 224) over a threshold number of training iterations.

8. The method (300) of claim 7, wherein executing a training iteration (222) from the threshold number of training iterations comprises:

   sampling a square error $\sigma^{-2}$ from a gamma distribution;
   sampling one or more model error parameters $\beta$ from a multivariate normal distribution; and
   sampling the uncertainty parameter $\theta$ from a truncated normal distribution.

9. The method (300) of any one of the preceding claims, wherein:

   the object comprises a coupling in an aerostructure (102); and
   predicting, using the predictive model, the one or more properties of a new sample of the object (330) comprises predicting ignition properties of the coupling in the aerostructure.

10. The method (300) of claim 9, further comprising rejecting the coupling based on a determination that the predicted ignition properties indicate that the coupling comprises an ignition source when an electrical impulse is introduced into the coupling.

11. A system (500), comprising:

a memory (508) having executable instructions stored thereon; and
one or more processors (502) configured to execute the executable instructions to cause the system (500) to:

generating a training data set including a plurality of exemplars, each exemplar of the plurality of exemplars including ground-truth values for one or more properties of a sample of an object and corresponding predicted values for the one or more properties of the sample of the object, the corresponding predicted values for the one or more properties of the sample of the object being generated based on a computational model of the object;
training a predictive model to predict the one or more properties of samples of the object based on the training data set; and
predicting, using the predictive model, one or more properties of a new sample of the object.

12. The system (500) of claim 11, wherein the predictive model comprises a linear regression model (220) in which the ground-truth values for the one or more properties correspond to a dependent variable $y$ in the linear regression model and the corresponding predicted values for the one or more properties correspond to an independent variable x in the linear regression model.

13. The system (500) of claim 12, wherein to train the predictive model, the one or more processors (502) are configured to cause the system (500) to jointly learn one or more model error parameters $\beta$ and a random measurement error $\varepsilon$ based on a difference between the ground-truth values for the one or more properties and the corresponding predicted values for the one or more properties.

14. The system (500) of claim 11, wherein the predictive model comprises a Markov Chain Monte Carlo, (MCMC, model (222) in which the ground-truth values for the one or more properties correspond to a dependent variable in the MCMC model and a function of the corresponding predicted values x for the one or more properties and an uncertainty parameter $\theta$ corresponds to an independent variable in the MCMC model.

15. The system of claim 14, wherein to train the predictive model, the one or more processors (502) are configured to cause the system (500) to learn the uncertainty parameter $\theta$ based on an iterative process (210B, 222, 224) over a threshold number of training iterations.

FIG. 1

200A

| GENERATE TEST AND SIMULATION DATA FOR OBJECT 210A | → | GENERATE LINEAR REGRESSION 220 | → | PREDICT OBJECT PROPERTIES USING LINEAR REGRESSION MODEL 230A |

FIG. 2A

FIG. 2B

200B

GENERATE TEST AND SIMULATION DATA FOR OBJECT USING INPUT AND UNCERTAINTY VALUES
210B

ITERATIVELY GENERATE MARKOV CHAIN MONTE CARLO (MCMC) MODEL PARAMETERS
222

CONVERGENCE BETWEEN TEST AND SIMULATION DATA REACHED?
224

NO

YES

GENERATE MCMC MODEL USING MEAN ESTIMATES OF PARAMETERS
226

PREDICT OBJECT PROPERTIES USING MCMC MODEL
230B

EP 4 614 397 A1

15

300

BEGIN

GENERATE A TRAINING DATA SET INCLUDING A PLURALITY OF EXEMPLARS, EACH EXEMPLAR INCLUDING GROUND-TRUTH VALUES FOR ONE OR MORE PROPERTIES OF A SAMPLE OF AN OBJECT AND CORRESPONDING PREDICTED VALUES FOR THE ONE OR MORE PROPERTIES OF THE SAMPLE OF THE OBJECT — 310

TRAIN A PREDICTIVE MODEL TO PREDICT THE ONE OR MORE PROPERTIES OF SAMPLES OF THE OBJECT BASED ON THE TRAINING DATA SET — 320

PREDICT, USING THE PREDICTIVE MODEL ONE OR MORE PROPERTIES OF A NEW SAMPLE OF THE OBJECT — 330

END

FIG. 3

FIG. 4

FIG. 5

Europäisches
Patentamt

European
Patent Office

Office européen
des brevets

# EUROPEAN SEARCH REPORT

**Application Number**

EP 25 15 4160

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 055 639 B1 (CAY PELIN [US] ET AL) 6 July 2021 (2021-07-06) * columns 30,31; figure 13 * ----- | 1-15 | INV. G06N7/01 G06F30/27 G06N20/00 G06N20/20 |
| | | | **TECHNICAL FIELDS SEARCHED (IPC)** |
| | | | G06N G06F |

The present search report has been drawn up for all claims

| Place of search | Date of completion of the search | Examiner |
|---|---|---|
| The Hague | 13 June 2025 | Falco, Gabriele |

EPO FORM 1503 03.82 (P04C01)

## ANNEX TO THE EUROPEAN SEARCH REPORT
## ON EUROPEAN PATENT APPLICATION NO.

EP 25 15 4160

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2025

| Patent document cited in search report | Publication date | Patent family member(s) | Publication date |
|---|---|---|---|
| US 11055639 B1 | 06-07-2021 | NONE | |

For more details about this annex : see Official Journal of the European Patent Office, No. 12/82

EPO FORM P0459